# EUROPEAN PATENT SPECIFICATION

(11) **EP 2 337 244 B1**
(45) Date of publication and mention of the grant of the patent: **28.09.2016**
(21) Application number: 10193549.2
(22) Date of filing: 02.12.2010
(51) Int. Cl.: H01S 3/106, H01S 5/14, H01S 3/08, H04B 10/60, H04B 10/63

(54) **METHOD AND DEVICE FOR HOMODYNE RECEPTION OF AN OPTICAL SIGNAL**
VERFAHREN UND VORRICHTUNG ZUM HOMODYNE-EMPFANG EINEN OPTISCHEN SIGNAL
PROCEDE ET EQUIPEMENT DE RECEPTION HOMODYNE D'UN SIGNAL OPTIQUE

(30) Priority: 21.12.2009 FR 0906197
(43) Date of publication of application: 22.06.2011
(73) Proprietor: ALCATEL LUCENT, 92100 Boulogne-Billancourt (FR)
(72) Inventor: Bertran Pardo, Oriol, 91620, NOZAY (FR); Zami, Thierry, 91620, NOZAY (FR)
(74) Representative: Berthier, Karine

(56) References cited:
- EP-B1- 1 125 347
- US-A1- 2006 245 766
- TSUKAMOTO S ET AL: "Coherent demodulation of 40-Gbit/s polarization-multiplexed QPSK signals with 16-GHz spacing after 200-km transmission", 2005 OPTICAL FIBER COMMUNICATIONS CONFERENCE TECHNICAL DIGEST (IEEE CAT. NO. 05CH37672) IEEE PISCATAWAY, NJ, USA,, vol. 6, 6 March 2005 (2005-03-06), pages 85-87, XP010833521, ISBN: 978-1-55752-783-7
- DUBREUIL N ET AL: "TUNABLE SELF-ADAPTIVE CAVITY LASER DIODE WITH WAVELENGTH ALL-OPTICAL ADDRESSING", PROCEEDINGS OF THE EUROPEAN CONFERENCE ON OPTICALCOMMUNICATION, XX, XX, vol. 3, 1 January 2004 (2004-01-01), page 600/601, XP009060284,

## Description

The present invention pertains to the field of optical communication networks, and more particularly means for protecting the network's connections and for retrieving signals by coherent detection within the egress node's receiver.

In order to meet users' demands, the capacities of communication networks are constantly increasing. Nonetheless, as it is very expensive to completely change a network's technology, operators are seeking to develop higher-performing equipment which is compatible with already-installed equipment.

The use of coherent detection, in combination with complex modulation formats, is a means for obtaining such compatibility.

Furthermore, in order to overcome any problems that may arise over a network connection, operators are installing optical protection paths which may be activated if there is a problem on the active optical path, i.e. the working path.

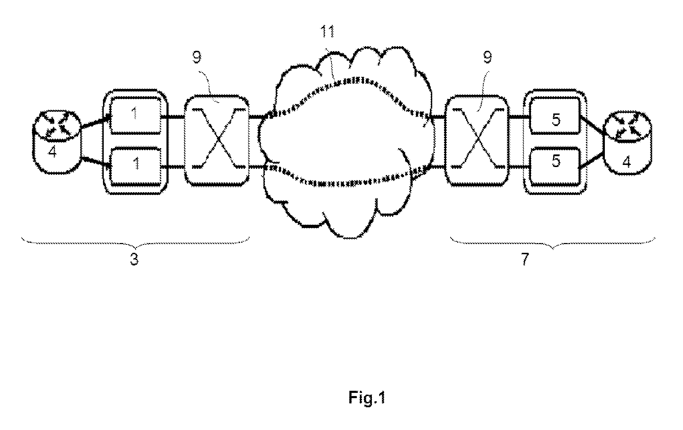

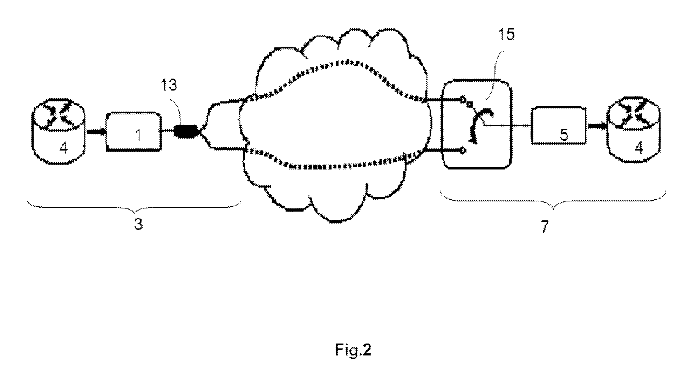

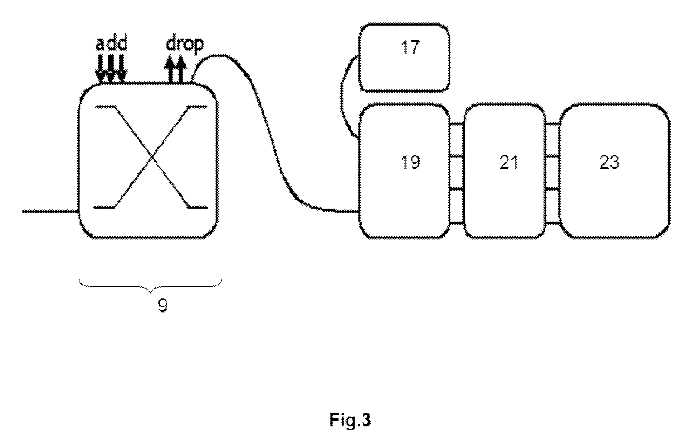

In the state of the art, two types of protection schemes exist:
First, there are electrical protection schemes, as depicted in Figure 1, in which all of the optical equipment of the transmitter 1 of the ingress node 3 connected to an electronic router 4 all the way to the receiver 5 of the egress node 7 connected to another electrical router 4, with optical cross connects (OXCs) 9 and optical transmission means 11 along the way, are doubled. This solution is high-performance and makes it possible to activate the protection connection in a minimal amount of time (because the signals are received at two separate receivers 5), but it is very expensive because the equipment that is needed is doubled (in particular the transmitters 1 and optical receivers 5).
Second, there are optical protection schemes, as depicted in Figure 2, in which the output of the transmitter 1 is connected to an optical coupler 13 making it possible to split the signal, and wherein a switch 15 makes it possible to select the working path or protection path. Nonetheless, if signals are detected using a coherent receiver, the signals associated with that technique are retrieved as described in Figure 3, in which the transmitted signal is mixed with a signal of a local oscillator 17 by a coherent mixer 19 so as to retrieve different components of the mixed signal, these components being transmitted to a sampler 21 and then to a digital signal processing device 23 in order to decode the information contained by the transmitted signal based on the retrieved components. However, this retrieval technique requires a local oscillator 17 producing a signal of approximately the same wavelength as the transmitted signal. Thus, switching the working path over to the protection path (which may correspond to a different wavelength) requires knowing the wavelength of the protection signal (generally predefined by the network's control plane) and tuning the local oscillator to the newly received wavelength. Thus, the time taken to set up the protection connection (if an incident occurs on the working connection) includes the time taken by the control plane to react, the sending of a command to the local oscillator 17 by the control plane, and the tuning of the local oscillator 17. This time is non-negligible, and leads to a significant loss of information whenever the bitrate is high. Other prior art system can be found disclosed in TSUKAMOTO S ET AL: "Coherent demodulation of 40-Gbit / s polarization-multiplexed QPSK signals with 16-GHz spacing after 200-km transmission", EP-1 125 347 B1 and US 2006/245766.

The goal of the present invention is therefore to overcome the aforementioned drawbacks of the state of the art and to disclose a method for reducing the time taken to adapt the receiver when the wavelength of the transmitted signal varies, such as when a protection connection is set up.

Thus, the present invention discloses a method for homodyne reception, wherein a coherent mixer combines a received optical signal with a baseline optical signal delivered by a local oscillator whose wavelength is within a predefined interval around the wavelength of the received optical signal in order to produce interference signals corresponding to a beat between the received optical signal and the baseline signal and intended to be detected by photodiodes, wherein said local oscillator comprises a Fabry-Pérot laser cavity comprising a photorefractive holographic medium, said received optical signal being supplied to said laser cavity whenever its wavelength varies so as to produce a baseline signal.

According to another aspect of the present invention, the photorefractive holographic medium is a crystal of cadmium telluride (CdTe).

According to an additional aspect of the present invention, the polarization state of the optical signal delivered by the local oscillator and transmitted to the coherent mixer is aligned with a predetermined polarization state.

According to an additional aspect of the present invention, analog-digital converters sample the detected signals and a digital signal processing device processes the sampled signals in order to demodulate a data signal.

According to another aspect of the present invention, the received optical signal is polarization division multiplexed.

The invention also pertains to a method for protecting an optical communication network whose connections between a transmitter and receiver comprise an active optical path and a protection optical path, wherein the receipt of a signal within the receiver is carried out according to the previously described method for receiving a signal, and wherein the receiver's input switches to the optical protection path whenever an incident occurs on the active optical path.

According to another aspect of the present invention, the switchover is done by a switch.

According to an additional aspect of the present invention, the active optical path signals have different wavelengths within said receiver.

According to an additional aspect of the present invention, the signals of the active optical paths and optical protection paths are transmitted, at the transmitter's output, by an optical coupler to respective optical paths.

The present invention also pertains to a device for retrieving a received optical signal, comprising:
- a local oscillator intended to produce a baseline optical signal,
- a coherent mixer comprising two inputs intended to receive both the received optical signal and the baseline signal, and outputs intended to transmit components of the mixed signal,
- a sampler comprising photodiodes and analog-digital converters,
- a digital signal processing module,
wherein said local oscillator comprises a Fabry-Pérot laser cavity comprising a photorefractive holographic medium, said received optical signal being supplied to said laser cavity whenever its wavelength varies so as to produce a baseline signal whose wavelength is within a predefined interval around the wavelength of the received signal so as to produce a beat between the received signal and the baseline signal within the coherent mixer,

The invention further comprises an optical node of a protection optical device, said protection device comprising an active optical path and a protection optical path, said optical paths connecting an optical emitter and an optical receiver, said optical node comprising:
- means for switching the active optical path over to the protection optical path in the event of an incident on the active optical path.
- demodulation means comprising:
   - a local oscillator intended to produce a baseline optical signal,
   - a coherent mixer comprising two inputs intended to receive both the signal transmitted by one of the optical paths and the baseline signal, and outputs intended to transmit components of the mixed signal,
   - a sampler comprising photodiodes and analog-digital converters,
   - a digital signal processing module,
wherein the local oscillator comprises a Fabry-Pérot laser cavity comprising a photorefractive holographic medium, the signal transmitted by one of the optical paths being supplied by the laser cavity (26), said oscillator being configured to transmit a baseline signal whose wavelength is within a predefined interval around the wavelength of the signal, supplied to said local oscillator so as to produce a beat between the two signals within the coherent mixer.

Other characteristics and benefits of the invention will become apparent from the following description, given with reference to the attached drawings, which by way of non-limiting example depict one possible embodiment.

In these drawings:
- Figure **1** depicts an electrical protection diagram;
- Figure **2** depicts an optical protection diagram;
- Figure **3** depicts a diagram of a signal-retrieval device comprising a coherent demodulation according to the state of the art;
- Figure **4** depicts a diagram of a signal-retrieval device comprising a coherent demodulation according to the present invention;
- Figure 5 depicts a diagram of a laser cavity of a slave laser according to the present invention;

The embodiments of the present invention pertain to a method for receiving and retrieving a signal, said method being adapted to coherent detection and using a slave laser in order to produce the baseline signal needed for retrieval.

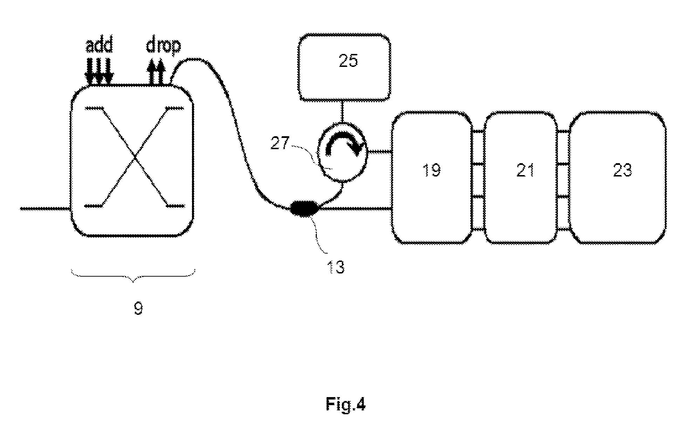

Figure 4 depicts a diagram of an optical receiver in accordance with the present invention.

The transmitted signal is sent to an optical coupler 13 in order to split the signal and to transmit part of the signal to a slave laser 25 by means of an optical circulator 27, and to transmit the other part of the signal directly to the first input of a coherent mixer 19.

The role of the slave laser 25 is to produce a continuous signal at the same frequency as the transmitted optical signal.

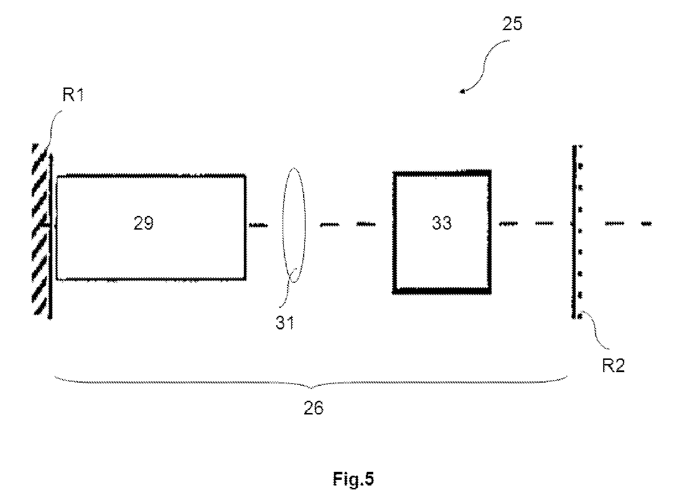

One example embodiment of the slave laser is described in Figure 5.

The slave laser 25 comprises a cavity 26 bounded by two mirrors R1 and R2, one of which is a semi-reflective mirror R2, thereby forming a Fabry-Pérot cavity 26. The cavity 26 comprises an amplifying medium 29, a collimating lens 31, and a photorefractive holographic medium 31.

This photorefractive holographic medium 31 may, for example, be a crystal of cadmium telluride (CdTe) forcing the laser to carry out single-mode wavelength oscillation over its entire range of operation. The structure of stationary waves associated with each of the longitudinal modes records an index hologram within the crystal. The writing of an index grating occurs after the electrical charges available within the crystal have moved. As the number of charges is fixed, a phenomenon whereby the gratings between them are erased and strengthened occurs as a result. This self-organization process, combined with the competition phenomena that take place within the amplifying medium 29, under some conditions lead to the laser 25 performing single-mode oscillation.

Additionally, injecting part of the transmitted signal into the cavity 26 causes the crystal's index grating to adapt, and thus the laser cavity 26 then emits around the wavelength imposed by the transmitted signal, even when the signal injection stops.

Thus, the slave laser 25 emits an optical signal whose wavelength approximately corresponds to the wavelength of the transmitted signal.

The wavelength of the baseline signal does not need to be strictly identical to the wavelength of the transmitted signal, but rather may be within a relatively close interval, so as to produce, by signal interference, a beat between the two signals, and thereby to generate a base-band signal which is then detected by the photodiodes. The width of the wavelength's interval is defined by the technical characteristics of the slave laser 25. This signal emitted by the slave laser 25 may then be used as a baseline for retrieving the signal comprising a coherent detection. To do so, the slave laser's optical signal 25 is transmitted on the second input of the coherent mixer 19 by means of the optical circulator 27.

Furthermore, the polarization of the signal emitted by the slave laser 25 and transmitted to the coherent mixer 19 must be known when the signal penetrates into the coherent mixer, in order to enable the retrieval of the transmitted signal. Thus, the polarization state of the optical signal derived from the slave laser is aligned with a predetermined polarization state.

The coherent mixer 19 generates components of the mixed signal resulting from interference between the baseline signal and the transmitted signal.

Different embodiments exist depending on the signals' mode of polarization and the coherent detection system used.

According to one preferential mode, the signals are modulated using quadrature phase shift keying (QPSK), with the signals being detected on two polarizations and the non-alignment of the polarization axes being corrected numerically so that four photodiodes and four analog-digital converters are necessary.

Nonetheless, other modulation formats may be used.

Additionally, the alignment of the polarization axes may be done mechanically. In this situation, detection may be carried out on a single polarization, and two photodiodes as well as two analog-digital converters are sufficient.

Furthermore, the slave laser 25 requires that the control signal (i.e. the transmitted signal, in our situation) arrives with a certain power level within the laser cavity's 26 preferential polarization state. Thus, according to one embodiment of the present invention, the transmitted signals are polarization division multiplexed (PDM), which makes it possible to prevent the control signal of the slave laser 25 from arriving with a polarization orthogonal to the slave laser 25 cavity's 26 preferential polarization state. The components of the mixed signal are then sent to the sampler 21.

Within the sampler 21, the signals are detected by photodiodes. In quadrature phase shift keying, four photodiodes deliver four quadrature phase-shifted electrical signals. The electrical signals are then sampled by analog-digital converters and transmitted to a digital signal processing device 23.

Thus, unlike the tunable laser 17 used in the state of the art requiring a command from the control plane and a certain length of time to tune when the receiver is switching a signal at a certain wavelength to another signal at a different wavelength, the slave laser makes it possible to automatically and quickly tune to the protection signal's wavelength, and thereby makes it possible to reduce the time needed to implement the protection connection. Additionally, implementing the present invention's embodiments has a limited cost, because the changes compared to a signal-retrieving device comprising coherent demodulation according to the state of the art only involve replacing the tunable laser 17 (corresponding to the local oscillator) with a slave laser 25, and using an optical coupler 13 and an optical circulator 27 so as to transmit part of the transmitted signal to the slave laser 25, then to transmit the baseline signal derived from the slave laser 25 to the coherent mixer 19.

Owing to the use of a slave laser 25, the embodiments of the present invention make it possible to reduce the time needed to adapt the signal-retrieving circuit comprising a coherent detection whenever the wavelength of the transmitted signal changes, and consequently make it possible to use an optical protection scheme while also using coherent detection. The present invention therefore makes it possible to limit the quantity of signals lost in the event of an incident on an active connection, and to limit the cost needed to implement effective protection.

## Claims

1. A method for homodyne reception, wherein a coherent mixer (19) combines a received optical signal with a baseline optical signal delivered by a local oscillator (25) whose wavelength is within a predefined interval around the wavelength of the received optical signal in order to produce interference signals corresponding to a beat between the received optical signal and the baseline signal and intended to be detected by photodiodes, wherein said local oscillator (17, 25) comprises a Fabry-Pérot laser cavity (26) comprising a photorefractive holographic medium (33), said received optical signal being supplied to said laser cavity whenever its wavelength varies so as to produce a baseline signal.

2. A method for receiving a signal according to claim 1, wherein the photorefractive holographic medium (26) is a crystal of cadmium telluride (CdTe).

3. A method for receiving a signal according to one of the preceding claims, wherein the polarization state of the optical signal delivered by the local oscillator (25) and transmitted to the coherent mixer (19) is aligned with a predetermined polarization state.

4. A method for receiving a signal according to one of the preceding claims, wherein analog-digital converters sample the detected signals and a digital signal processing device processes the sampled signals in order to demodulate a data signal.

5. A method for receiving a signal according to one of the preceding claims, wherein the received optical signal is polarization division multiplexed.

6. A method for protecting an optical communication network whose connections between a transmitter (1) and a receiver (5) comprise an active optical path and a protection optical path, wherein the receipt of a signal within the receiver (5) is carried out according to one of the claims 1 to 5 and wherein the receiver's (5) input switches to the optical protection path whenever an incident occurs on the active optical path.

7. A protection method according to claim 6, wherein the switchover is carried out by a switch (15).

8. A protection method according to claim 6 or 7, wherein the active optical path signals have different wavelengths within said receiver (5).

9. An device for retrieving a received optical signal comprising:
- a local oscillator (17, 25) intended to produce a baseline optical signal,
- a coherent mixer (19) comprising two inputs intended to receive both the received optical signal and the baseline signal, and outputs intended to transmit components of the mixed signal,
- a sampler (21) comprising photodiodes and analog-digital converters,
- a digital signal processing module (23),
wherein said local oscillator (17, 25) comprises a Fabry-Pérot laser cavity (26) comprising a photorefractive holographic medium (33), said received optical signal being supplied to said laser cavity whenever its wavelength varies so as to produce a baseline signal whose wavelength is within a predefined interval around the wavelength of the received signal so as to produce a beat between the received signal and the baseline signal within the coherent mixer (19).

10. An optical node of an optical protection device, said protection device comprising an active optical path and a protection optical path, said optical paths connecting an optical emitter and an optical receiver, said optical node comprising:
- means for switching (15) the active optical path over to the protection optical path in the event of an incident on the active optical path,
- demodulation means:
- a local oscillator (17, 25) intended to produce a baseline optical signal,
- a coherent mixer (19) comprising two inputs intended to receive both the received optical signal and the baseline signal, and outputs intended to transmit components of the mixed signal,
- a sampler (21) comprising photodiodes and analog-digital converters,
- a digital signal processing module (23),
wherein said local oscillator (17, 25) comprises a Fabry-Pérot laser cavity (26) comprising a photorefractive holographic medium (33), said received optical signal being supplied to said laser cavity whenever its wavelength varies so as to produce a baseline signal whose wavelength is within a predefined interval around the wavelength of the received signal so as to produce a beat between the received signal and the baseline signal within the coherent mixer (19).

## Patentansprüche

1. Verfahren zum homodynen Empfang, wobei ein kohärenter Mischer (19) ein empfangenes optisches Signal mit einem optischen Basissignal kombiniert, welches von einem lokalen Oszillator (25) zur Verfügung gestellt wird, dessen Wellenlänge innerhalb eines vordefinierten Intervalls um die Wellenlänge des empfangenen optischen Signals liegt, um Interferenzsignale zu produzieren, die einem Takt zwischen dem empfangenen optischen Signal und dem Ausgangssignal entsprechen und von Photodioden festgestellt werden sollen, wobei besagter lokaler Oszillator (17, 25) einen Fabry-Perot-Laserresonator (26) umfasst, ein photorefraktives holografisches Medium (33) umfassend, wobei besagtes empfangenes, optisches Signal besagtem Laserresonator immer dann zur Verfügung gestellt werden, wen seine Wellenlänge dergestalt variiert, dass ein Basissignal produziert wird.

2. Verfahren für den Empfang eines Signals nach Anspruch 1, wobei das photorefraktive holografische Medium (26) ein Cadmiumtelluridkristall (CdTe) ist.

3. Verfahren für den Empfang eines Signals nach einem der vorgenannten Ansprüche, wobei der Polarisationszustand des von dem lokalen Oszillator (25) gelieferten und an den kohärenten Mischer (19) übermittelten, optischen Signals an einen vordefinierten Polarisationszustand angeglichen wird.

4. Verfahren für den Empfang eines Signals nach einem der vorgenannten Ansprüche, wobei Analog-/Digital-Wandler die festgestellten Signale die festgestellten Signale abtasten und eine Verarbeitungsvorrichtung für digitale Signale die abgetasteten Signale verarbeitet, um ein Datensignal zu demodulieren.

5. Verfahren für den Empfang eines Signals nach einem der vorgenannten Ansprüche, wobei das empfangene optische Signal polarisationsmultiplext ist.

6. Verfahren für den Schutz eines optischen Kommunikationsnetzwerks, dessen Verbindungen zwischen einem Sender (1) und einem Empfänger (5) einen aktiven optischen Pfad umfassen, wobei der Empfang eines Signals im Empfänger (5) nach einem der Ansprüche 1 bis 5 erfolgt und wobei der Eingang des Empfängers (5) immer dann zum optischen Schutzpfad umschaltet wenn sich auf dem aktiven optischen Pfad ein Zwischenfall ereignet.

7. Verfahren nach Anspruch 6, wobei das Umschalten von einem Schalter (15) vorgenommen wird.

8. Schutzverfahren nach Anspruch 6 oder 7, wobei die Signale des aktiven optischen Pfads innerhalb besagten Empfängers (5) unterschiedliche Wellenlängen haben.

9. Vorrichtung für das Abrufen eines empfangenen optischen Signals, umfassend:
- einen lokalen Oszillator (17, 25), der dafür vorgesehen ist, ein optisches Basissignal zu produzieren,
- einen kohärenten Mischer (19), welcher zwei Eingänge umfasst, die vorgesehen sind für den Empfang sowohl des empfangenen optischen Signals und des Basissignals, sowie Ausgänge, die vorgesehen sind für das Übermitteln von Komponenten des gemischten Signals,
- einen Sampler (21), welcher Photodioden und Analog-/Digital-Wandler umfasst,
- ein digitales Signalverarbeitungsmodul (23),
wobei besagter lokaler Oszillator (17, 25) einen Fabry-Pérot-Laserresonator (26) umfasst, welcher ein photorefraktives holografisches Medium (33) umfasst, wobei besagtes empfangenes optisches Signal besagtem Laserresonator immer dann zur Verfügung gestellt wird, wenn seine Wellenlänge dergestalt variiert, dass ein Basissignal produziert wird, dessen Wellenlänge innerhalb eines vordefinierten Intervalls um die Wellenlänge des empfangenen Signals liegt, so dass in dem kohärenten Mischer (19) ein Takt zwischen dem empfangenen Signal und Basissignal erzeugt wird.

10. Optischer Knoten einer optischen Schutzvorrichtung, wobei besagte Schutzvorrichtung einen aktiven optischen Pfad und einen optischen Schutzpfad umfasst, wobei besagte optische Pfade einen optischen Emitter und einen optischen Empfänger verbinden, wobei besagter optischer Knoten umfasst:
- Mittel für das Schalten (15) des aktiven optischen Pfads über den optischen Schutzpfad im Fall eins Vorfalls auf dem aktiven optischen Pfad,
- Demodulierungsmittel:
- einen lokalen Oszillator (17, 25), der dafür vorgesehen ist, ein optisches Basissignal zu produzieren,
- einen kohärenten Mischer (19), welcher zwei Eingänge umfasst, die vorgesehen sind für den Empfang sowohl des empfangenen optischen Signals und des Basissignals, sowie Ausgänge, die vorgesehen sind für das Übermitteln von Komponenten des gemischten Signals,
- einen Sampler (21), welcher Photodioden und Analog-/Digital-Wandler umfasst,
- ein digitales Signalverarbeitungsmodul (23),
wobei besagter lokaler Oszillator (17, 25) einen Fabry-Pérot-Laserresonator (26) umfasst, welcher ein photorefraktives holografisches Medium (33) umfasst, wobei besagtes empfangenes optisches Signal besagtem Laserresonator immer dann zur Verfügung gestellt wird, wenn seine Wellenlänge dergestalt variiert, dass ein Basissignal produziert wird, dessen Wellenlänge innerhalb eines vordefinierten Intervalls um die Wellenlänge des empfangenen Signals liegt, so dass in dem kohärenten Mischer (19) ein Takt zwischen dem empfangenen Signal und Basissignal erzeugt wird.

## Revendications

1. Procédé de réception homodyne, dans lequel un mélangeur cohérent (19) combine un signal optique reçu avec un signal optique de référence délivrés par un oscillateur local (25) dont la longueur d'onde est comprise dans un intervalle prédéfini autour de la longueur d'onde du signal optique reçu afin de produire des signaux d'interférence correspondant à un battement entre le signal optique reçu et le signal de référence et destinés à être détectés par des photodiodes, dans lequel ledit oscillateur local (17, 25) comprend une cavité laser Fabry-Pérot (26) comprenant un support holographique photoréfractif (33), ledit signal optique reçu étant fourni à ladite cavité laser chaque fois que sa longueur d'onde varie afin de produire un signal de référence.

2. Procédé de réception d'un signal selon la revendication 1, dans lequel le support holographique photoréfractif (26) est un cristal de tellurure de cadmium (CdTe).

3. Procédé de réception d'un signal selon l'une des revendications précédentes, dans lequel l'état de polarisation du signal optique délivré par l'oscillateur local (25) et transmis au mélangeur cohérent (19) est aligné avec un état de polarisation prédéterminé.

4. Procédé de réception d'un signal selon l'une des revendications précédentes, dans lequel des convertisseurs analogique-numérique échantillonnent les signaux détectés et un dispositif de traitement de signaux numériques traite les signaux échantillonnés afin de démoduler un signal de données.

5. Procédé de réception d'un signal selon l'une des revendications précédentes, dans lequel le signal optique reçu est multiplexé par répartition en polarisation.

6. Procédé de protection d'un réseau de communication optique dont les connexions entre un émetteur (1) et un récepteur (5) comprennent un chemin optique actif et un chemin optique de protection, dans lequel la réception d'un signal dans le récepteur (5) est effectuée selon l'une des revendications 1 à 5 et dans lequel l'entrée du récepteur (5) commute sur le chemin de protection optique chaque fois qu'un incident se produit sur le chemin optique actif.

7. Procédé de protection selon la revendication 6, dans lequel la commutation est effectuée par un commutateur (15).

8. Procédé de protection selon la revendication 6 ou 7, dans lequel les signaux du chemin optique actif ont des longueurs d'onde différentes dans ledit récepteur (5).

9. Dispositif pour récupérer un signal optique reçu comprenant :
- un oscillateur local (17, 25) destiné à produire un signal optique de référence,
- un mélangeur cohérent (19) comprenant deux entrées destinées à recevoir le signal optique reçu et le signal de référence, et des sorties destinées à transmettre des composantes du signal mélangé,
- un échantillonneur (21) comprenant des photodiodes et des convertisseurs analogique-numérique,
- un module de traitement de signaux numériques (23),
dans lequel ledit oscillateur local (17, 25) comprend une cavité laser Fabry-Pérot (26) comprenant un support holographique photoréfractif (33), ledit signal optique reçu étant fourni à ladite cavité laser chaque fois que sa longueur d'onde varie afin de produire un signal de référence dont la longueur d'onde est dans un intervalle prédéfini autour de la longueur d'onde du signal reçu afin de produire un battement entre le signal reçu et le signal de référence dans le mélangeur cohérent (19).

10. Noeud optique d'un dispositif de protection optique, ledit dispositif de protection comprenant un chemin optique actif et un chemin optique de protection, lesdits chemins optiques reliant un émetteur optique et un récepteur optique, ledit noeud optique comprenant :
- des moyens pour commuter (15) entre le chemin optique actif et le chemin optique de protection en cas d'incident sur le chemin optique actif,
- des moyens de démodulation :
- un oscillateur local (17, 25) destiné à produire un signal optique de référence,
- un mélangeur cohérent (19) comprenant deux entrées destinées à recevoir le signal optique reçu et le signal de référence, et des sorties destinées à transmettre des composantes du signal mélangé,
- un échantillonneur (21) comprenant des photodiodes et des convertisseurs analogique-numérique,
- un module de traitement de signaux numériques (23),
dans lequel ledit oscillateur local (17, 25) comprend une cavité laser Fabry-Pérot (26) comprenant un support holographique photoréfractif (33), ledit signal optique reçu étant fourni à ladite cavité laser chaque fois que sa longueur d'onde varie afin de produire un signal de référence dont la longueur d'onde est dans un intervalle prédéfini autour de la longueur d'onde du signal reçu afin de produire un battement entre le signal reçu et le signal de référence dans le mélangeur cohérent (19).
